Europäisches Patentamt

European Patent Office

Office européen des brevets

(11) Publication number: **0 207 523**
A2

## (12) EUROPEAN PATENT APPLICATION

(21) Application number: 86109124.7

(22) Date of filing: 04.07.86

(51) Int. Cl.⁴: **H 04 N 7/20**

(30) Priority: 05.07.85 ES 544928

(43) Date of publication of application:
07.01.87 Bulletin 87/2

(84) Designated Contracting States:
AT BE CH DE FR GB IT LI LU NL SE

(71) Applicant: TELEVES, S.A.
Conjo de Abajo, 23
Santiago de Compostela(La Coruna)(ES)

(72) Inventor: Bescansa de la Gándara, Ramón
Monte Sollans
Teo La Coruna(ES)

(72) Inventor: García Campos, Gerardo
Santiago de Guayaquil 6-40 Izda
Santiago de Compostela La Coruna(ES)

(72) Inventor: Solleiro Pereira, Esteban
C/Rosa, 31-70 A
Santiago de Compostela La Coruna(ES)

(74) Representative: Prato, Roberto et al,
c/o Ingg. Carlo e Mario Torta Via Viotti 9
I-10121 Torino(IT)

(54) Radio-frequency signal processing unit.

(57) A unit for processing radio-frequency signals received via
satellite, first converted to a first intermediate frequency (I.F.),
and filtered, amplified, converted, demodulated and proces-
sed by the unit itself, for obtaining standard TV audio and
video signals; the aforementioned unit being formed using
microcomponents facing in parallel manner and welded to
the conducting tracks on a printed circuit. Such a technique
provides, among other things, for reducing the overall size of
the unit, and for reducing electromagnetic interference be-
tween the circuit blocks and the unit itself.

FIG. 1

Croydon Printing Company Ltd

EP 0 207 523 A2

# RADIO-FREQUENCY SIGNAL PROCESSING UNIT

The present invention relates to a unit for processing radio-frequency (R.F.) signals received from a telecommunication satellite, and first converted to a first intermediate frequency (I.F.) in the receiving head of a parabolic aerial; the said signals being filtered, amplified, converted, demodulated and processed for obtaining standard TV audio and video signals for processing a standard earth TV receiving channel. Such is achieved using microcomponents assembled on a printed circuit with their terminals connected, in facing and parallel manner, to the conducting islands of the said printed circuit. This provides for numerous advantages, as well as for enabling performance of the aforementioned functions using a small-size module, of the same size as those used on earth TV receiving units, thus enabling the said module to be incorporated on main receiving systems as an additional receiving unit having a R.F. output on a domestic TV receiving channel.

Satellites currently employed for relaying television broadcasts are all low-power, and suitable for various applications, such as communication, data, TV, etc.

The low power level of such satellites requires the use of large receiving aerials and converters with a very low noise factor.

Both these devices render the cost of a receiving system well beyond the possibility of individual users. Doubtless, however, such high cost may be absorbed on main or cable systems by dividing the cost of the aerial and converter among the total number of users in the community.

Installing a main aerial involves the user of fixed-tuning demodulating units, one for each received satellite TV channel, owing to the necessity for modulating the audio and video signals of each satellite TV channel to radio frequencies compatible with earth TV receiving channels.

The demodulating units currently available on the world market for satellite TV reception include only two types:

- Continuous-tuning demodulators for individual reception, which operate as an auxiliary module on the TV receiver, similar to a TV tuner;

- Fixed-tuning demodulators for cable TV (CATV) applications - professional receiving equipment governed by national cable network specifications.

Such limited supply has led to an awkward situation in that, being designed for non-European markets, the products currently being marketed worldwide are unsuited to the present European low-power satellite market.

Individual continuous-tuning units have been developed on DBS (direct broadcasting satellite) markets in Japan and the United States, where such units, requiring typical receiving parabola diameters of 0.5 to 0.8 m, are in strong demand, and the cost of individual high-power satellite systems is within the reach of individual users. The same does not apply, however, to the European low-power satellite market, owing to the large parabola diameter and, consequently, the high system cost involved.

Cable TV fixed-tuning demodulating units are designed for present pay cable TV networks and, being sophisticated, high-cost equipment, are governed by strict CATV specifications. Due to the high cost involved, the market for this type of unit is restricted to existing cable networks with only limited development in Europe.

As such, a definite need is felt for a new type of demodulating unit specifically designed for the main aerial market, whereby installation costs (for the aerial and converter) may be shared among a large number of users, with no need for additional high-cost CATV demodulating units.

A need has, therefore, arisen for a new type of demodulating unit compatible with existing main aerial (MATV) sets, obviously differing from the highly complex, cumbersome individual units currently available on the market, and which is compatible with existing main receiving systems.

Known receiving units as of present employ traditional technology, substantially consisting in forming circuits from printed circuit boards fitted with a number of components, the terminals of which are fitted through the circuit boards and welded to one of the metalized faces in the circuits themselves; the latter being gripped between the component terminals via conducting islands marked on the printed faces.

On conventional circuits, each operating block or circuit assembly responsible for performing a given function is usually separated on the printed circuit board and, in many cases, must be enclosed in an airtight screen for preventing unwanted electromagnetic radiation from being emitted or received from nearby circuits. The ease with which electromagnetic radiation is emitted and received is apparently due to the high frequencies involved, the large component volume resulting from such frequency, or the use of terminals having excessively long connections, to the extent that the said components function in exactly the same way as a broadcasting and receiving aerial.

Solutions devised for overcoming these drawbacks include increased volume for separating the circuits from one another; abundant screening; lengthening the circuitry for allowing more space between potential contact points; and sophisticated circuitry for improving circuit stability. Though effective operation-wise, the resulting units are both cumbersome and expensive to manufacture.

The unit according to the present invention overcomes the aforementioned drawbacks by employing compact, surface-mounting (SMA) components with flat terminals. Its size is such that the reactive terminal components are practically limited to the printed circuit tracks, which are designed in such a manner as to constitute the reactive components of the circuit itself.

Its volume is the minimum technologically possible for the said component to be handled manually.

The said microcomponents present flat terminals enabling them to be welded, in facing and parallel manner, to the conducting islands on the printed circuit.

Stability and gain of the amplifiers on the unit are exceptionally high over the GHz frequency range, and with no need for increasing size or employing large-size circuits or additional screening.

On conventional circuits, it does not pay to use the printed circuit tracks as reactive circuit components in that, as already stated, the value of such reactive parts is impaired by the component terminals. Using SMA components, however, not only solves this problem by preventing interference of the terminal, but also enables highly effective use to be made of the printed circuit tracks as circuit components; which is an enormous advantage, in terms of automated assembly, in that, unlike conventional components, positioning of the component on the printed circuit is no longer a critical factor during manufacture. Furthermore, automated assembly of R.F..circuits operating over the GHz frequency range means not only a big cut in manufacturing cost, but also extremely consistent manufacturing quality.

The printed circuit boards are marked off into conducting islands having a given profile, so as to obtain inductive and capacitive reactive components with respective loss resistances, and so as to form, by grouping into given configurations, transformers, filters and impedance coupling and/or matching circuits, which, being mechanically stable, are also electrically stable.

Connecting SMA components to the circuits formed on the metal printed circuit board tracks is perfectly straightforward, both manually and mechanically. What is more, the present state of the art enables the formation of a wide range of such circuits, by offering SMA components in the form of diodes for various applications, condensers, inductors, resistors, potentiometers and transistors of various types.

The volume of SMA component circuits is considerably less than that of traditional circuits. For example, a finished circuit, including the printed circuit board, may be as little as one fifth, or less, the thickness of a traditional circuit, which means the total volume of the unit according to the present invention equals that of an amplifying unit on a main earth TV receiving system. On main TV receiving systems, therefore, the satellite receiving unit according to the present invention represents an additional module, differing from the others only as to the input and output connectors.

SMA microcomponents may be positioned automatically, quality-controlled and assembled by customers. The microcomponent is positioned correctly on the printed circuit and secured to the same by means of adhesive resistant to the fusion temperature of solder. In like manner, the component terminals are secured facing, in parallel manner, and contacting the printed circuit board area to which they are to be welded in traditional manner by means of soft soldering. The component is designed to withstand the heat of the solder and, thanks to the surface arrangement of the terminals facing the conducting islands on the board, a minimum amount of material is sufficient for ensuring perfect soldering.

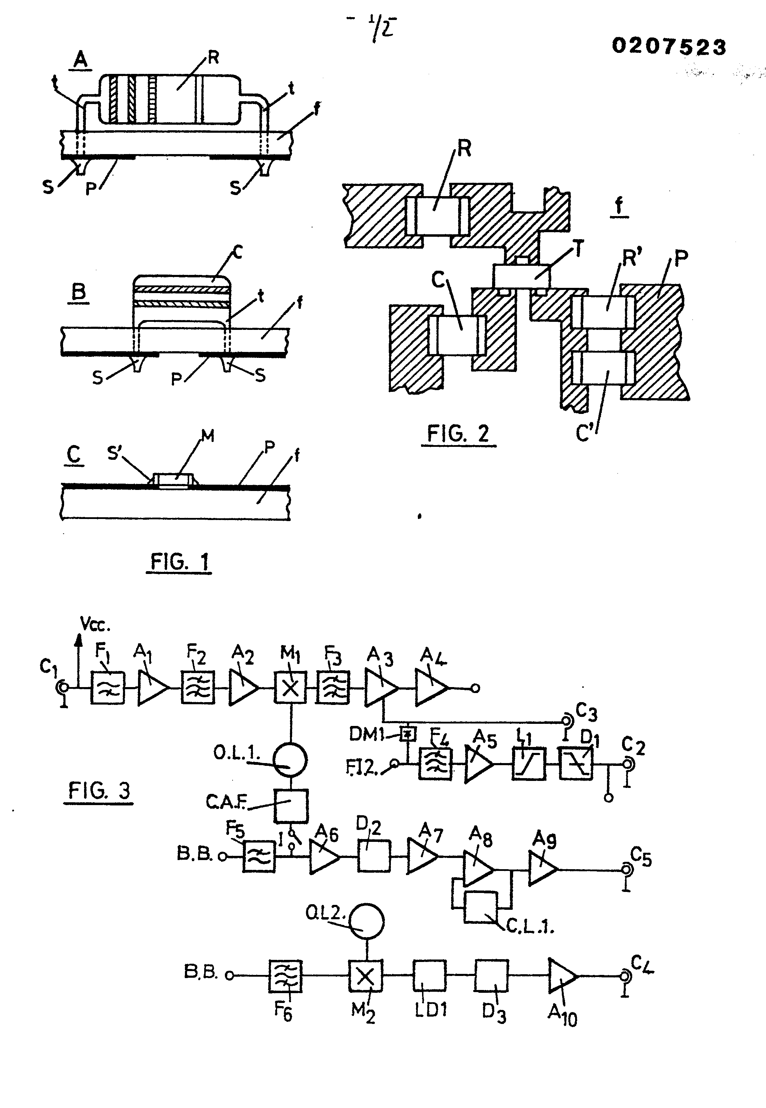

Fig.1 shows the difference in size between conventional and SMA components. Fig.1A, for example, shows a resistor R with terminals D, mounted on a printed circuit board of which can be seen the insulating part F and the conducting part B. Component R has its terminals fitted through the printed circuit board, and is soldered to the conducting island by means of solder S. Fig.1B shows a condenser C mounted in the same way as in Fig.1A. Fig.1C shows an SMA component M equivalent to the foregoing two components and, though similar in appearance to a condenser and resistor, much smaller in size. Using component M, the negative effect of the terminals on component R or C is eliminated.

Fig.2 shows part of a printed circuit board, the insulating material F of which (not shown) presents conducting islands B fitted with resistive components R, R', capacitive components C or C', and a transistor T. The opposite side of the printed circuit may be fitted with other components or a metal conducting sheet for grounding the printed circuit. Under no circumstances do the SMA component terminals pass through the insulating plate on the circuit.

The satellite TV receiving unit according to the present invention is designed preferably for use on main (SMATV) systems.

The unit is compatible with converters having an intermediate frequency of 950 to 1,750 MHz, can operate with signals throughout the entire range, and is designed for adaption to a channel anywhere within the said range. It is provided with a built-in modulator enabling output on a TV channel preferably within the 40-860 MHz range. The said modulator receives audio and video signals either via external inputs or via a program decoder. At times, video and audio outputs are availale simultaneously.

Design of the unit is fully modular, the unit itself being mounted on a plate screwed directly onto the wall. Assembling several units on one plate, together with respective supply sources and passive elements for signal distribution, provides for an easy-assembly, high-performance satellite receiving system.

Provision is made for a direct automatic gain control voltage output for exact parabola positioning.

The unit is composed of the following stages:

I.F. AMPLIFIER AND CONVERTER

This amplifies the I.F. signal from the first converter on the parabola, which signal is first filtered and then converted in such a manner as to convert the incoming I.F. band to an intermediate frequency preferably of 130 MHz. Using microcomponents, the gain of this part is at least 48 DB, achieved using a maximum of four amplifying stages. The 130 MHz intermediate frequency is purely by way of a non-limiting example, and may be replaced by other frequencies.

I.F. DEMODULATOR

This provides for amplifying, filtering and limiting the converter output to a given output level.

The demodulator is provided with an automatic gain control loop, which controls the level of the signal supplied to the limiter within a given input signal range. At the same time, the voltage from the AGC is made externally accessible for facilitating parabola positioning.

The 130 MHz signal is demodulated in a quadrature discriminator to obtain video output signals plus the sub-carrier containing the audio data.

VIDEO PROCESSOR

Once the video signal has been obtained, it is amplified, de-emphasized, filtered and processed in a clamping circuit for setting reference levels for restoring the continuous component.

AUDIO PROCESSOR

The demodulated compound signal is fed into an audio sub-carrier demodulator pre-tuned to the channel sub-carrier frequency.

MODULATOR

The video and audio signals modulate the carriers of any channel normally within the 40-860 MHz range. The audio sub-carrier adapts separately to standard frequency values.

Fig.s 3 and 4 show a block diagram of the circuitry in a non-limiting embodiment of the present invention.

All the circuits are mounted on a one- or two-sided glass-fibre support, using the chip component SMA (surface mounting assembly) technique, and housed in perfectly screened metal modules.

The first I.F. signal from the parabola converter is received via connector C1, either directly or via a distributor (not shown). Connector C1 also supplies the supply voltage Vdc for the said converter.

Via a high-pass input filter F1, the signal is supplied to wide-band input amplifier A1, the output of which is connected to a tunable channel filter F2. The output signal is again amplified in A2.

The input filter and amplifiers are formed from circuit-printed and SMA chip components (condensers, resistors, transistors, diodes, etc.) for compactness and a high degree of stability.

The gain of tunable amplifier A2 ranges, depending on the band, from at least 12 to 18 DB. Oscillator circuit OL1 proportions an oscillating frequency, preferably 130 MHz higher than the intermediate frequency at the input, so as to obtain a tuning voltage for adjusting, together with an oscillating frequency regulating coil, the capacity of a number of varicap diodes and, consequently, also tuning of the channel.

By virtue of the surface mounting chip technique, the entire assembly described so far is housed in a single screened compartment, which would otherwise consist of numerous elements and occupy a much larger volume.

The signals from tuned amplifier A2 and the oscillator circuit are sent to a ferrite mixer M1 connected to a mixing transistor, the output of which supplies a second I.F. signal, preferably on the 115-145 MHz band. Depending on the received channel, the said band width is regulated by means of three tunable circits F3 connected to the output of mixer M1 and consisting of ferrite-core coils and condensers (trimmers).

The resulting signal is then sent to an amplifier A3, the gain of which varies according to the level of the signal detected at the input of the I.F. modulator, and which functions as an automatic gain control on A3. Automatic gain control is regulated within an ample margin of at least 10 DB.

The second I.F. signal is then amplified in A4 to give a total second I.F. gain of at least 50 plus or minus 2 DB.

Total gain of the converter is minimum 43 DB for the first I.F. high band and 45-48 DB for the low band.

Using microcomponents, the amplifier for amplifying the second I.F. signal with the said gain is housed entirely in a single screened compartment providing for maximum stability.

Part of the signal received in the I.F. demodulator is picked up in DM1 and sent to the automatic gain control circuit in A3.

The remainder of the signal is sent to the actual I.F. demodulator circuit via a 115-145 MHz band-pass filter F4 in which the high and low part of the band is regulated by varying the inductance of the resonant circuit coils.

The said demodulating circuit presents an amplifier A5 having four stages (not shown), the first of which supplies the unit threshold.

The said amplifying stages present limiting circuits for supplying the cut signal to demodulator D.1.

In like manner, the second I.F. response curve is obtained at both the extreme limits and within the first band.

The said second I.F. signal is formed and cut in L1 and sent to demodulator D.1, from which there is obtained a base-band signal BB on connector C2.

The said base-band signal from the I.F. demodulator is fed into the video processor, the input of which presents a built-in low-pass filter F5 only enabling passage of the video band, and eliminating the audio signals (operating frequency traps).

The signal is then amplified and inverted in amplifier A6, and sent on to de-emphasizing network D2, in conformance with specifications. The high frequencies are attenuated by means of a variable resistor.

The signal is again amplified and inverted in amplifier A7, and then sent on to the clamping circuit.

This stage eliminates the residual triangular wave and clamps the sync pulses and the white level by combining the amplifying A8 and clamping C.L.1 stages.

The video signal is again amplified in A9, and its amplification and output level regulated by means of potentiometers, to give a video signal in C3.

The output of video input filter F5 supplies the automatic frequency control signal (AFC) of local oscillator O.L.1 for obtaining I.F.2.

An AFC switch 1 is employed, in that the channel must be tuned without activating the automatic frequency control. On connector C5, video signals are available for viewing on a TV monitor. The base-band signal from the I.F. demodulator is also fed into a sub-carrier amplifier with series and parallel resonant filters F6.

The audio signal is processed in a converter circuit M2 with a local oscillator O.L.2, discriminated in LD1, and de-emphasized in D3.

The processed signal is sent on to an audio amplifier A10 in which the output level is regulated by means of a variable potentiometer, so as to produce, in C4, a basic audio signal for subsequent amplification and high-volume auditioning.

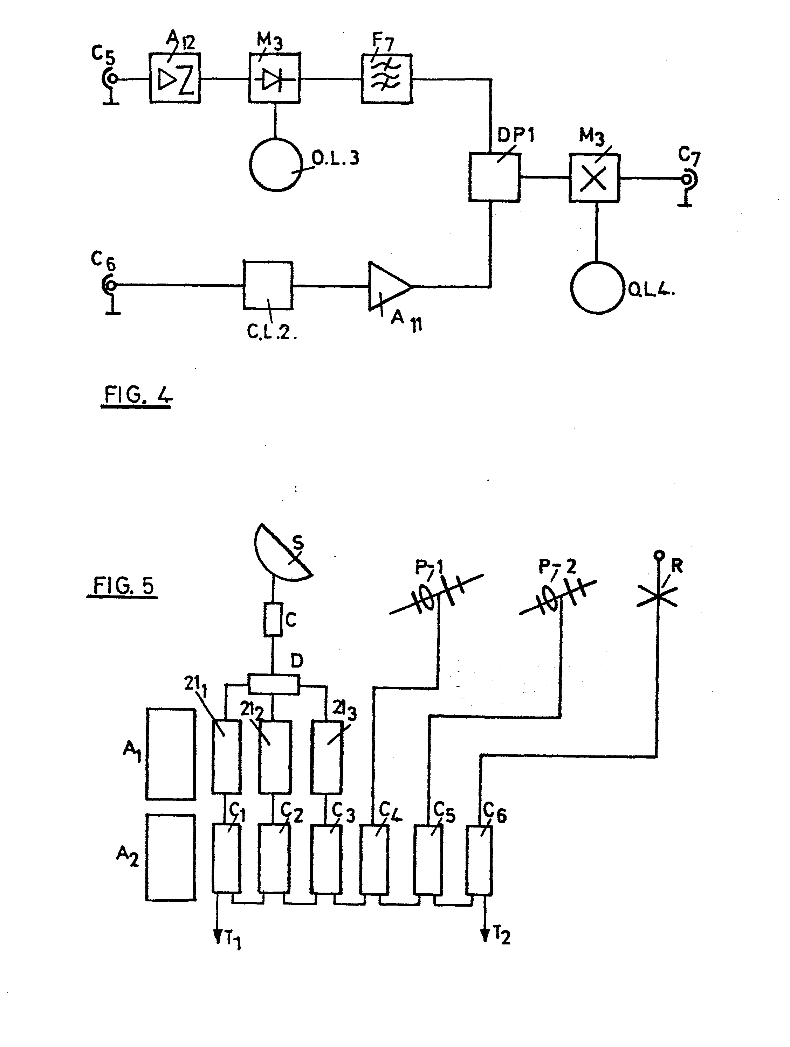

Fig.4 shows the circuit for generating a standard domestic TV channel from audio and video signals.

The audio and video signals from the respective processors and an external decoder are supplied to C5 and C6 respectively.

In the case of C5, the audio signal is subjected to a first limited amount of amplification in A12, for subsequently modulating a carrier generated in O.L.3 on modulating stage M3. It is then sent for filtering in F7 and, from there, to a diplexer circuit DP1 for combining it with the video signal.

The video signal through C6 is clamped in C.L.2 and amplified in A11 so as to reach audio-video diplexer DP1.

By means of mixer M3, the signals combined in DP1 modulate a transposition oscillator O.L.4 to a standard channel frequency.

The manner in which each of the aforementioned functions or processes is performed depends on the type of components employed. Furthermore, the circuitry employed may be formed using integrated circuits in keeping with technical progress, thus enabling the overall size of the unit to be even further reduced.

Fig.5 shows a main receiving and distribution station for domestic radio and TV, embodying the unit according to the present invention.

Aerials S, P-1, P-2 and R are for reception respectively from a satellite, a first link transmitter, a second link transmitter and an AM/FM radio.

Domestic TV and radio signals are subjected to channel C4, C5 and C6 amplification for home distribution via T and T2.

The satellite signal in S is converted to a first intermediate frequency and amplified in parabola head C, after which, it is distributed in D consisting, in this case, of three units U1, U2 and U3 according to the present invention and differing solely as to tuning. The only difference between the output signals of the said unit and earth TV signals lies in the channel, which is compatible with existing local channels. For each locality, a satellite program will be selected and distributed to the community.

Blocks A1 and A2 represent the respective supplies for the units according to the present invention, and for the main channel amplifiers. To those skilled in the art it will be clear that changes may be made to the embodiment of the unit as described herein without, however, departing from the scope of the present invention.

## CLAIMS

1) - A unit for processing radio-frequency signals received via satellite, the said unit comprising intermediate-frequency amplifying circuits, a second-intermediate-frequency converting circuit, an intermediate-frequency demodulator circuit, a video processor circuit, an audio processor circuit, and a video and audio modulator circuit with external access via input, output and supply connectors, characterised by the fact that the said circuits are formed on a printed circuit on which are mounted, on the conducting islands on the surface of the said printed circuit, active and/or passive microcomponents welded to the flat terminal surface of the said microcomponents, facing the conducting tracks on the said printed circuit, the various said circuits being connected by means of the said conducting islands; provision being made, on the same printed circuit, for at least radio-frequency filtering, tuning and impedance attenuating and matching elements, formed on the said conducting islands or by means of microcomponents, and adjustable oscillators and filters for tuning at least one radio-frequency input channel and at least one output channel; the whole being designed in the form of a compact modular unit having input, output and supply connectors enabling access to earth TV video and audio receiving systems.

2) - A unit as claimed in Claim 1, characterised by the fact that stability and gain on the intermediate-frequency amplifying circuits are achieved by reducing parasitic reactance, by surface-welding the microcomponent terminals in facing and parallel manner on the conducting islands on the surface of the said printed circuit.

3) - A unit as claimed in Claim 1, characterised by the fact that, for reducing the size of the said unit, the active circuit components are formed by connecting the conducting islands on the said printed circuit to the said microcomponents, the terminals of which are surface-welded in facing and parallel manner on the conducting islands of the said printed circuit.

4) - A unit as claimed in Claim 1, characterised by the fact that the unit input is tuned to a satellite receiving channel, preferably on the 950-1,750 MHz radio-frequency band, which is maintained constant during operation.

5) - A unit as claimed in Claim 1, characterised by the fact that the unit output is preferably tuned to the 47-870 MHz band, which is maintained constant during operation.

6) - A unit as claimed in Claim 1, characterised by the fact that the said circuits are housed in a compact modular unit designed to be incorporated on a main aerial system as an additional element having signal input and output connectors, forming part of an earth TV receiving system, connected to the system units and supplied by its own main receiving system; the said satellite signal being distributed, via the main distribution network, over a TV channel preferably on the 47-870 MHz band.

7) - A unit as claimed in Claims 1, 4 and 5, characterised by the fact that the same unit provides for receiving a satellite channel preferably on the 950-1,750 MHz band, and for converting the same preferably to the 47-870 MHz band, in such a manner that any input channel may be converted to any output channel on the said bands.

8) - A unit as claimed in Claims 1 and 2, characterised by the fact that screening between partial radio-frequency circuits is eliminated by arranging the said microcomponents with their terminals surface-welded in facing and parallel manner to the conducting islands on the surface of the said printed circuit.

9) - A unit as claimed in Claim 1, characterised by the fact that the said tuning and filtering circuits are formed by means of capacitive and inductive components set out on the conducting surface of the said printed circuit, in conjunction with active and/or passive microcomponents surface-welded in facing manner to the conducting islands on the said printed circuit.

10) - A unit as claimed in Claim 1, characterised by the fact that the said microcomponents preferably consist of transistors, diodes, resistors, condensers, potentiometers and coils.

11) - A unit as claimed in Claims 1, 4, 5 and 6, characterised by the fact that, subsequent to demodulation and processing, audio and video signals are available inside the said unit; the said signals providing for modulating the carriers generated on the said unit for processing the said TV channel preferably on the 47-870 MHz band.

FIG. 2

FIG. 1

FIG. 3

FIG. 4

FIG. 5